Europäisches Patentamt

European Patent Office

Office européen des brevets

(11) Publication number: **0 048 151**
**B1**

(12) **EUROPEAN PATENT SPECIFICATION**

(45) Date of publication of patent specification: **18.07.84**

(51) Int. Cl.³: **G 11 B 5/09**

(21) Application number: **81304192.8**

(22) Date of filing: **14.09.81**

(54) A PCM signal processor.

(30) Priority: **16.09.80 JP 128332/80**

(43) Date of publication of application:
**24.03.82 Bulletin 82/12**

(45) Publication of the grant of the patent:
**18.07.84 Bulletin 84/29**

(84) Designated Contracting States:
**DE FR GB IT NL**

(73) Proprietor: TOKYO SHIBAURA DENKI KABUSHIKI
KAISHA
72, Horikawa-cho Saiwai-ku
Kawasaki-shi Kanagawa-ken 210 (JP)

(72) Inventor: Kojima, Tadashi c/o Patent Division
Tokyo Shibaura Denki K.K. 72, Horikawa-cho
Saiwai-ku Kawasaki-shi Kanagawa-ken,210 (JP)

(74) Representative: Newstead, Michael John et al,
Haseltine Lake & Co. 28 Southampton Buildings
Chancery Lane
London, WC2A 1AT (GB)

(56) References cited:
EP - A - 0 029 226
FR - A - 2 423 935
FR - A - 2 440 125
FR - A - 2 443 171
GB - A - 2 019 168

PATENT ABSTRACTS OF JAPAN, vol. 5, no.
118, July 30, 1981, page P73/790

PATENT ABSTRACTS OF JAPAN, vol. 4, no. 90,
July 27, 1980, page P17-572

(56) References cited:
IEEE TRANSACTIONS ON CONSUMER
ELECTRONICS, vol. CE-24, no. 4, November
1978, NEW YORK (US) Y. ISHIDA et al.: "A
rotary-head PCM recorder employing error
correction technique", pages 526-533

JOURNAL OF AUDIO ENGINEERING SOCIETY,
vol. 28, no. 4, April 1980, NEW YORK (US)
"Consumer Use PCM Encoder-Decoder 1979-6.
Electronic Industries Assoc. of Japan Technical
File of the Stereo Technical Committee and the
Video Technical Committee STC-007", pages
260-265

## Description

The present invention relates to a PCM (pulse code modulation) signal processor according to the precharacterising part of claim 1.

As prior art there can be mentioned French Patent Specification No. 2,423,935.

In the field of audio engineering, digital technology has been utilized mostly in professional equipment design. A proliferation of consumer video cassette tape recorders has, however, recently led to the use of digital technology in consumer audio equipment.

A pulse code modulation (PCM) recording and playback system made possible by combining a video tape recorder (VTR) and digital technology has a strikingly broader dynamic range with practically no wow and flutter compared with current analogue tape recorders. Their frequency and distortion characteristics are also much superior to current systems. Having all of these various advantages, the applications of digital technology in the audio engineering field are considered to be most effective.

However, unlike for current analogue systems, a PCM audio system using VTRs requires a digital signal processor for signal transformation to or from a TV signal of a standard system, such as the NTSC system, according to suitable signal format, on recording or reproducing the PCM signal.

As the PCM audio signal format, there may be used the format prescribed by the EIAJ (Electronic Industries Association of Japan) Technical File: STC—007, which employs bit error correction schemes together with interleaving techniques, as described in detail later.

Encoding of the PCM audio signals to a VTR signal according to the EIAJ format is practiced by delay interleaving of data words and an error correction check word and an error detection check word. Correspondingly, conventional PCM signal processors for decoding encoded PCM audio signals are provided with de-interleaving circuits of very large capacity.

It is an object of the present invention to provide a PCM signal processor reduced as regards the capacity of its de-interleaving circuit.

According to the present invention, there is provided a PCM signal processor for decoding PCM signals, and correcting their errors, from a TV format signal whose horizontal period includes a data block comprising plural data words, an error correction check word and an error detection check word, individually interleaved such that successive words in the PCM signal are in different blocks of the TV format signal, the said processor comprising:

means for demodulating the said data block from a TV format signal input to it;

means for converting the said data block to parallel signals respectively representing individual data words, the error correction check word and the error detection check word;

means for de-interleaving the said parallel signals, except the said error detection check word;

means for outputting the said parallel data words;

means for correcting errors in the said data words;

means for generating a syndrome word by combining the said parallel de-interleaved words, and applying the said syndrome word to the said error correcting means so that error correction is carried out by combining the said syndrome word with the said individual errors in the said words;

means for detecting a block error of the said data block by checking said parallelly converted data words and error correction check word with said error detection check word;

means for delaying error pointers output from the said block error detecting means so as to output differently delayed plural error pointers, the respective error pointers corresponding as regards their delay amounts with respective ones of the said de-interleaved data words and error correction check word;

means for detecting an error pointer pattern of individual ones of the said de-interleaved data words and error correction check word using the said error pointers supplied from the said error pointer delaying means; and

means for controlling the said error correcting operation of the said error correcting means using output signals supplied from the said error pointer pattern detecting means, characterised in that:

the said error pointer delaying means comprises a shift register having a plurality of outputs respectively corresponding to the said delay amounts.

The present invention will now be described by way of example with reference to the accompanying drawings, in which:

Figure 1 shows one type of word signal allocation for a horizontal line period of a TV signal according to the EIAJ format;

Figure 2 shows a control signal allocation for a horizontal line period;

Figure 3 shows another type of word signal allocation;

Figure 4A shows a signal allocation for an even vertical field period;

Figure 4B shows a signal allocation for an odd vertical field period;

Figure 5 is a block diagram of a conventional encoder for transforming PCM audio signals to VTR format signals;

Figure 6 is a block diagram of a prior art PCM signal decoder for restoring PCM signals from VTR format signals;

Figure 7 is a block diagram of one embodiment of a PCM signal processor according to the present invention; and

Figure 8 shows a further embodiment of an error pointer delaying circuit shown in Figure 7.

Throughout the drawings, the same reference letters and numerals will be used to designate like or equivalent elements.

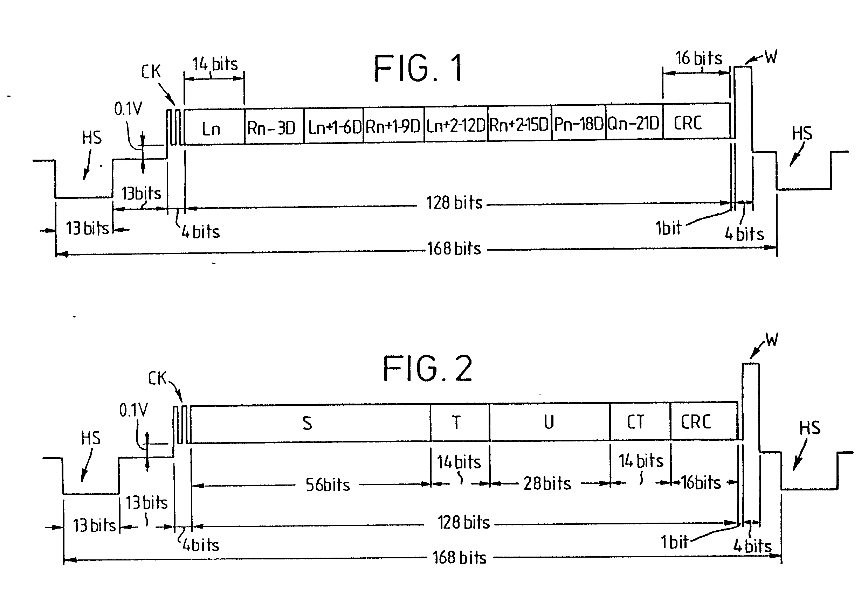

First, there will be described the EIAJ signal format referring to Figures 1 to 4B.

On PCM encoding of analogue audio signals, by way of example two channel stereophonic (L and R) analogue signals, the signals are individually sampled at a sampling frequency of about 44 kHz. Each piece of sampled data (i.e. one word) is transformed into a PCM data word of 14-bits or 16-bits and then allocated in a video signal portion of a standard television (TV) signal. Figure 1 shows an example of a waveform or data format of one horizontal scanning period (1H period) for the case where one word is of the 14-bit data form mentioned above. Three words are included per channel, and in total, six words Ln, Rn—3D, Ln+1—6D, Rn+1—9D, Ln+2—12D and Rn+2—15D are put in a video signal block in one horizontal line, with two check words P and Q for error correction and with one word CRC for error detection, all of which constitute a 9-word, 128-bis data block.

Word CRC consists of 16 bits, but all other words are 14 bits. The PCM data L and R according to Figure 1 respectively correspond to the left and right sampled data, and suffixes *n* represent the sampling order. In the format of Figure 1, the data is interleaved such that, in each sampled data, the six words and two check words P and Q, i.e. a total of eight words, are successively shifted by 16 blocks (i.e. 16 horizontal lines) for each word, and D in the aforementioned suffixes represents this number of blocks (D=16) of the interleave. In this case, the interleave of D=16 blocks is equivalent to a word-interleave of 3D=48 words.

In Figure 1, the period of one horizontal line (1H) is constituted by 168 bits. In this 168-bit interval, the horizontal synchronising signal HS which has 13 bits is placed, then a 4-bit clock signal CK for synchronization of data is placed after an interval of 13 bits, and then the aforementioned 128-bit data block is placed. The code of the data synchronization signal CK is, for instance, "1010". Also, after the 128-bit data block a "0" signal of one bit is placed, and then a white reference signal W with a pulse width of 4 bits is placed.

Figure 2 shows a 1H period in which a control signal data block is contained. This format is the same as that of Figure 1 except for the 128-bit control data block, including the horizontal synchronising signal HS and white reference signal W. The 128-bit control data block in this case is constituted by a 56-bit heading signal word S, a 14-bit content discrimination signal word T, a 28-bit address signal word U, a 14-bit control signal word CT and the aforementioned 16-bit error detection word CRC.

The content of the 14-bit control signal word CT is set as shown in Table 1 below.

TABLE 1

| Bit No. | Code Content | Control Content | Bit Content |
|---------|--------------|-----------------|-------------|
| 1 to 10 | No prescription | — | 0 |
| 11 | Dubbing inhibition code | Absent | 0 |
| 12 | P correction discrimination code | Present | 0 |
| 13 | Q correction discrimination code | Present | 0 |
| 14 | Pre-emphasis discrimination code | Present | 0 |

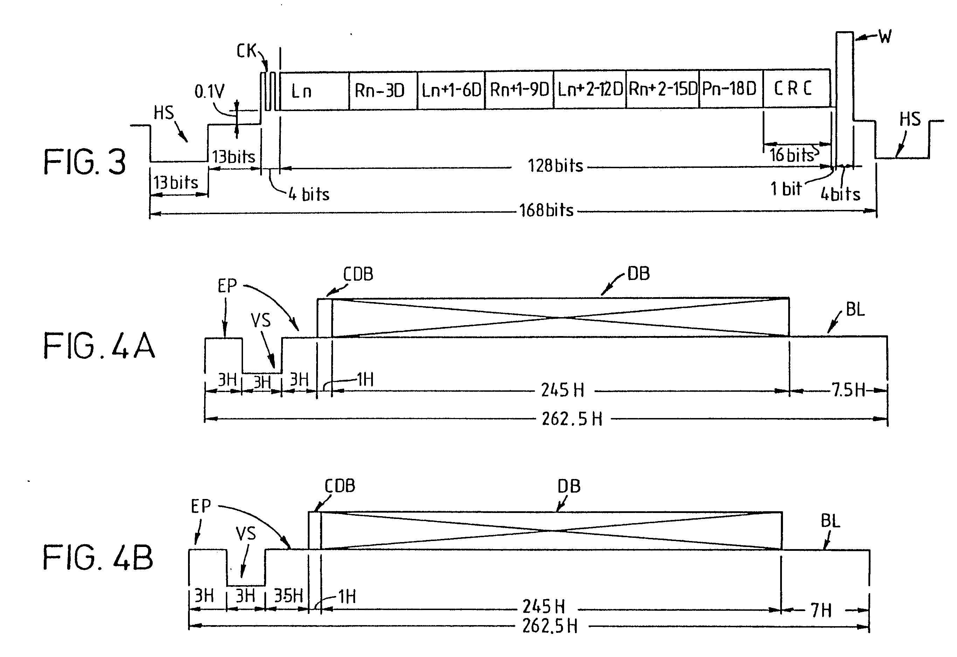

In Table 1, the Q correction discrimination code is "0" representing the "presence" for the case when the word of the PCM audio signal is constituted by 14 bits, while where one word is constituted by 16 bits, for instance as in the data format shown in Figure 3, the Q correction discrimination code is "1" representing "absence".

Figure 3 shows an example of the data block in which one word of the PCM audio signal mentioned above is constituted by 16 bits, that is, the 128-bit data block is constituted by six 16-bit words of the left and right channel audio signal data L and R, a 16-bit error correction word P and a 16-bit error detection word CRC, i.e. a total of eight words.

The above data signals for a 1H period are arranged in one vertical scanning period filed in a manner as shown, for instance, in Figures 4A and 4B. Figure 4A corresponds to an odd field, and Figure 4B corresponds to an even field. At the outset of each field, an equivalent pulse EP and a vertical synchronising signal VS are arranged, a control signal block CDB is provided in the 10-th horizontal line in the odd field (see Figure 4A) and in the 10.5-th horizontal line in the even field (see Figure 4B), and then 245 horizontal lines with data block DB are provided, the remaining horizontal lines constituting a blank period BL.

Of the 262.5 horizontal lines constituting one field in Figures 4A and 4B, the 16.6 lines other than the 246 lines in which the aforementioned control signal block CDB and data block DB are provided correspond to the vertical blanking period of the standard television signal.

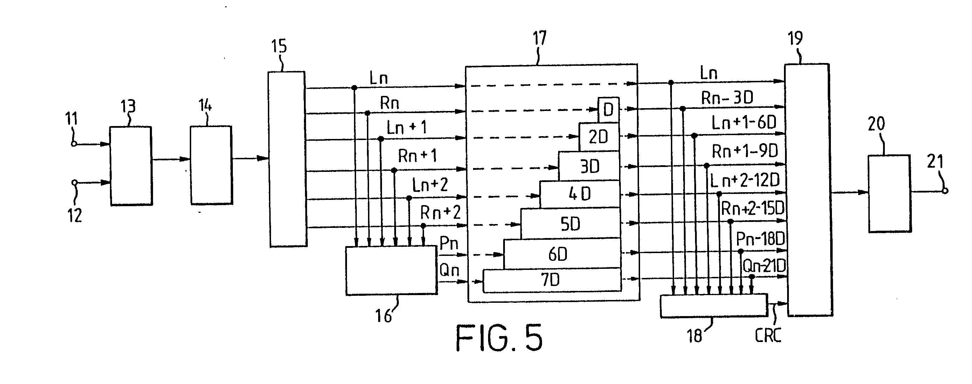

Figure 5 is a block diagram showing a conventional encoder for converting the analogue audio signals into the interleaved PCM data format signals to be placed in the data block of a horizontal period shown in Figure 1.

Through respective input terminals 11 and 12 are applied left and right analogue audio signals into a multiplexer 13.

Multiplexer 13 samples the left and right audio signals alternately i.e. at different timings at a sampling frequency of about 44 Khz. Each sampled signal outputted from multiplexer 13 is applied to an analogue-to-digital converter (hereinafter referred to as an A/D converter) 14 where the sampled signals, are converted into PCM signal data words (hereinafter referred to as data words) individually consisting of 14 bits. The data words are applied to a serial-to-parallel converter (hereinafter referred to as an S/P converter) 15 where the data words are divided into individual words, $L_n$, $R_n$, $L_{n+1}$, $R_{n+}$, $L_{n+2}$ and $R_{n+2}$, then outputted from six different output terminals corresponding to respective ones of the data words after being compressed in time. These data words are respectively applied to a parity signal generator 16 where check words P and Q are generated in accordance with operations for those data words. Six data words $L_n$ to $R_{n+2}$ and two check words P and Q are applied to an interleave circuit 17 comprising delay circuits, through which data word $L_n$ passes in a non-delayed form, but the other five data words $R_n$, $L_{n+1}$, $R_{n+1}$, $L_{n+2}$ and $R_{n+2}$ and the two check words P and Q are delayed by different delay amounts, D to 7D respectively (the meaning of D is aforementioned). The output words $L_n$ to $Q_n-21D$ from interleave circuit 17 are applied to an error detection check word generator (hereinafter referred to as an CRC generator) 18 where check word CRC for error detection is generated in accordance with an operation for the words $L_n$ to $Q_n-21D$. The eight interleaved words $L_n$ to $Q_n-21D$ from interleave circuit 17 and check word CRC from CRC generator 18 are applied to a parallel-to-serial converter (hereinafter referred to as a P/S converter) 19 where the nine words $L_n$ to CRC are converted into a single-line time-shared signal configuration. The output of P/S converter 19 is applied to a TV signal modulator 20 where the output is converted to a TV format signal. As a result, the data block, shown in Figure 1, including six data words $L_n$ to $R_{n+2}-15D$ and three check words $P_n-18D$ to CRC in turn are formed, and applied to VTRs (not shown) through an output terminal 21.

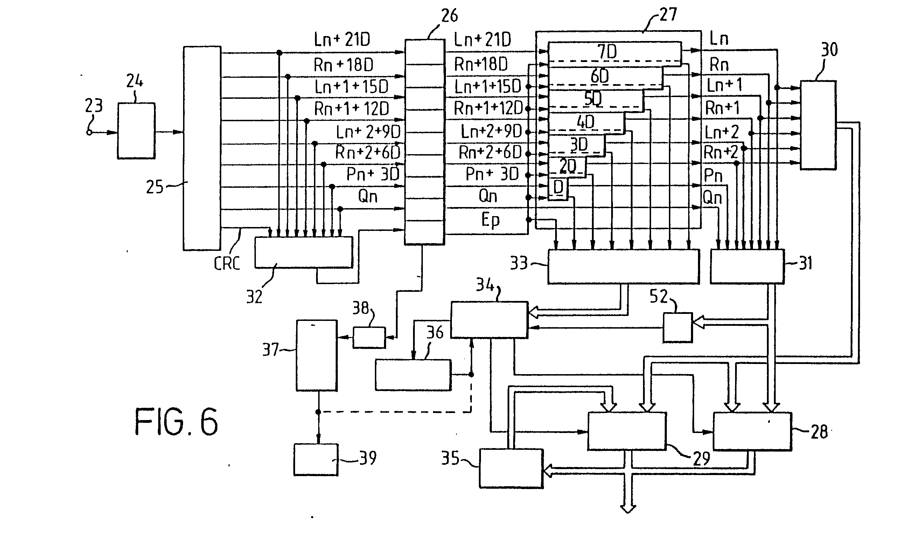

Figure 6 is a block diagram showing a prior art PCM audio signal decoder. Through an input terminal 23 there are applied modulated PCM audio signals, reproduced from a VTR (not shown), to TV signal demodulator 24 in which the data block including PCM data words shown in Figure 1 are extracted and shaped as regards their waveforms. The data block is applied to an S/P converter 25 where the data block is divided into individual PCM words $L_{n+21D}$, $R_{n+18D}$, $L_{n+1+15D}$, $R_{n+1+12D}$, $L_{n+2+9D}$, $R_{n+2+6D}$, $P_{n+3D}$, $Q_n$ and CRC, and the PCM words are outputted from nine parallel output terminals respectively. Then, the PCM words are applied to a buffer memory 26 where the PCM words are expanded in time, and where fluctuations of the PCM words are compensated for, the word CRC only being applied to a block error detector 32.

Six data words outputted from buffer memory 26, $L_{n+21D}$ to $R_{n+2+6D}$, and two check words, $P_{n+3D}$ and $Q_n$, are applied to a de-interleave circuit 27 comprising delay circuits through which seven words, $L_{n+21D}$, $R_{n+18D}$, $L_{n+1+15D}$, $R_{n+1+12D}$, $L_{n+2+9D}$, $R_{n+2+6D}$ and $P_{n+3D}$, are delayed by different delay amounts 7D to D respectively, but check word $Q_n$ passes in a non-delayed form. Therefore, the output signals of de-interleave circuit 27 are put in the original word order, i.e. $L_n$, $R_n$, $L_{n+1}$, $R_{n+1}$, $L_{n+2}$, $R_{n+2}$, $P_n$ and $Q_n$ existing at the input terminals of interleave circuit 17 of the encoder shown in Figure 5.

Data words $L_n$, $R_n$, $L_{n+1}$, $R_{n+1}$, $L_{n+2}$ and $R_{n+2}$ outputted from de-interleave circuit 27 are applied to both an error corrector 28 and an error compensator 29 through a one-block delay circuit 30. Furthermore, data words $L_n$ to $R_{n+2}$, together with check words $P_n$ and $Q_n$, outputted from de-interleave circuit 27 are applied to a syndrome generator 31 where a syndrome word $S_n$ is generated by calculation from words $L_n$ to $Q_n$. Syndrome word $S_n$ is

applied to error corrector 28 for error correction of data words Ln to Rn+2 if they include any error bits.

The aforementioned divided words, i.e. the data words Ln+21D, Rn+18D, Ln+1+15D, Rn+1+12D, Ln+2+9D and Rn+2+6D and two error correction check words Pn+3D and Qn, are also applied to the error detector 32 together with error detection check word CRC, where an error pointer for each one of words Ln+21D to Qn, i.e. EpLn+21D to EpQn, is generated under the control of check word CRC. Each error pointer Ep is applied to an error pointer pattern detector 33 through the de-interleave circuit 27 where it is processed in a similar manner to the PCM words Ln+21D to Qn. As a result, the error pointer for data word Ln, i.e. EpLn, is applied to error pointer pattern detector 33 from de-interleave circuit 27 at a time when data word Ln is outputted from de-interleave circuit 27; the error pointer for data word Rn, i.e. EpRn, is applied to error pointer pattern detector 33 at a time when data word Rn is outputted from de-interleave circuit 27; and so on, the other error pointers EpLn+1, EpRn+1, EpLn+2, EpRn+2, EpPn and EpQn being applied to the error pointer pattern detector 33 at times when the respective words Ln+1, Rn+1, Ln+2, Rn+2, Pn and Qn are outputted from de-interleave circuit 27. In error pointer pattern detector 33, any errors occurring in each word are detected on the basis of the patterns of error pointers EpLn to EpQn. The output of error pointer pattern detector 33 is applied to a correction controller 34 together with a 1-bit signal Cs generated from a syndrome word checker 52 which generates a logic "1" if one or more error bits exist in signals Ln to Qn on checking syndrome word Sn. Outputs of correction controller 34 are connected to control terminals of error corrector 28 and error compensator 29. As a result, if any errors occur in data words Ln to Rn+2 outputted from one-block delay circuit 30, the erroneous data words are corrected by syndrome word Sn at error corrector 28. If not, the erroneous data words are compensated at error compensator 29, on using corresponding words in one previous data block fed-back through a one-block delay circuit 35.

Also, an output of correction controller 34 is connected to a de-interleave error detector 36 for supplying via controller 34 control signals to error corrector 28 and error compensator 29 at times of occurrence of any missed de-interleavings at de-interleave circuit 27. An input terminal of a muting signal generator 37 is connected with the output of an overflow detector 38 which detects overflowing of buffer memory 26. The muting signal generated at muting signal generator 37 is applied to a muting circuit 39 where any erroneous bits of words are muted into a logic "0", under the control of the muting signal.

The PCM audio signal decoder shown in Figure 6 has several limitations as described below. First, de-interleave circuit 27 needs a large capacity for delaying error pointers Ep by 7D to D respectively, as well as words Ln to Pn—18D. Furthermore, there are generally used 4-bit RAMs (random access memories) or 8-bit RAMs for de-interleave circuit 27. On the other hand, in the case of the words consisting of 16 bits, each word with the added error pointer Ep becomes a 17-bit word. As a result, many RAMs are needed, but some of them are not used effectively.

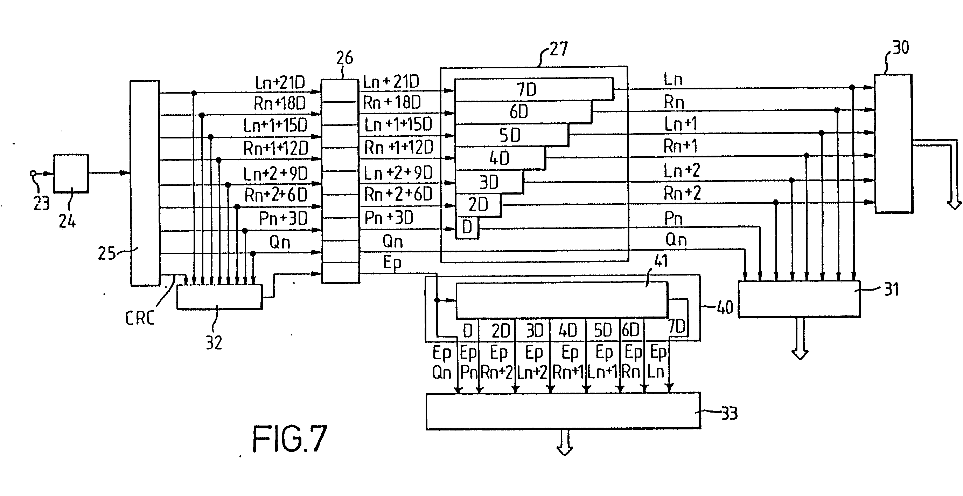

Referring now to Figure 7, there is shown a block diagram of a PCM audio signal decoder according to one embodiment of the present invention, which includes circuits substantially the same as circuits in the Prior Acts PCM audio signal detector shown in Figure 6, except circuits between a block error detector and an error pointer pattern detector. Therefore, explanations for the circuits substantially same as those of the Prior Art will be omitted from following description.

In Figure 7, an error pointer Ep generated via block error detector 32 is directly applied to error pointer pattern detector 33 and moreover is applied to it through an error pointer pattern delaying circuit 40 which comprise a serial type shift register 41 which has steps D, in total 7D, and has seven output terminals, one for each step. Therefore, the error pointer for data word Ln, i.e. EpLn, is applied to error pointer pattern detector 33 from the seventh output terminal of shift register 41 at a time when data word Ln is output from de-interleave circuit 27; the error pointer for data word Rn, i.e. EpRn, is applied to error pointer pattern detector 33 from the sixth output terminal of shift register 41 at a time when data word Rn is output from de-interleave circuit 27; and similarly, the other error pointers EpLn+1, EpRn+1, EpLn+2, EpRn+2 and EpPn are applied to error pointer pattern detector 33 from the fifth to first output terminals of shift register 41 respectively. On the other hand, the error pointer for check word Qn, i.e. EpQn, is directly applied to the error pointer pattern detector 33.

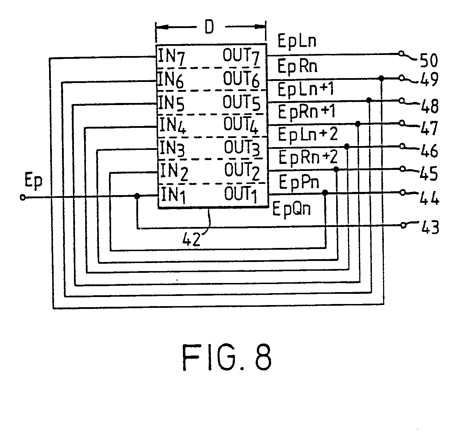

There is shown another embodiment of delay means for the error pointers Ep in Figure 8. The delay means is constituted by a parallel type shift register 42 which consists of seven register units each delaying an input signal by D.

In Figure 8, each error pointer Ep is applied to the error pointer pattern detector 33 (not shown) via terminal 43, as well as to input $IN_1$ of the first delay unit of register 42. The error pointer Ep on output $OUT_1$ of the first unit, delayed by D, is also applied to the error pointer pattern detector 33 via terminal 44, as well as to input $IN_2$ of the second unit, and so on, the error pointers Ep on outputs $OUT_2$ to $OUT_6$ of the second to sixth units being applied to the error pointer pattern detector 33 via terminals 45 to 49 respectively, as well as to inputs $IN_3$ to $IN_7$ of the respective next units. However an error pointer Ep on output $OUT_7$ of the seventh unit is only applied to the error pointer pattern detector 33 via terminal 50.

Therefore, error pointers EpLn, EpRn, EpLn+1, EpRn+1, EpLn+2, EpRn+2, EpPn and EpQn for words Ln, Rn, Ln+1, Rn+1, Ln+2, Rn+2, Pn and Qn respectively are obtained on terminals 50 to 43, similarly to the operation of the serial type shift register 41 shown in Figure 7.

## Claims

1. A PCM signal processor for decoding PCM signals, and correcting their errors, from a TV format signal whose horizontal period includes a data block comprising plural data words (Ln+21D, Rn+18D, Ln+1+15D, Rn+1+12D, Ln+2+9D, Rn+2+6D), an error correction check word (Pn+3D, Qn) and an error detection check word (CRC), interleaved such that successive words in the PCM signal are in different blocks of the TV format signal, the said processor comprising:

means (24) for demodulating the said data block from a TV format signal input to it;

means (25) for converting the said data block to parallel signals respectively representing individual data words, the error correction check word and the error detection check word;

means (27) for de-interleaving the said parallel signals, except the said error detection check word;

means (30) for outputting the said parallel data words;

means (28) for correcting errors in the said data words;

means (31) for generating a syndrome word by combining the said parallel de-interleaved words, and applying the said syndrome word to the said error correcting means so that error correction is carried out by combining the said syndrome word with the said individual errors in the said words;

means (32) for detecting a block error of the said data block by checking said parallely converted data words and data correction check word with said error detection check word;

means (40) for delaying error pointers (Ep) output from the said block error detecting means so as to output differently delayed plural error pointers (EpLn, EpRn, EpLn+1, EpRn+1 EpLn+2, EpRn+2, EpPn, EpQn), the respective error pointers corresponding as regards their delay amounts with respective ones of the said de-interleaved data words and error correction check word;

means (33) for detecting an error pointer pattern of individual ones of the said de-interleaved data words and error correction check word using the said error pointers supplied from the said error pointer delaying means; and

means (34) for controlling the said error correcting operation of the said error correcting means using output signals supplied from the said error pointer pattern detecting means, characterised in that:

the said error pointer delaying means comprises a shift register (41 or 42) having a plurality of outputs respectively corresponding to the said delay amounts.

2. A PCM signal processor according to Claim 1, characterised in that the said error pointer delaying means comprises a serial type shift register (41).

3. A PCM signal processor according to Claim 1, characterised in that the said error pointer delaying means comprises a parallel type shift register (42).

4. A PCM signal processor according to any one of Claims 1 to 3, characterised in that it further comprises means (29, 35) for compensating errors of the said de-interleaved data words using its previous output signals fed back delayed by one block, and the said error correcting operation controlling means (34) is connected for controlling the said error compensating means.

5. A PCM processor according to any preceding claim, characterised in that it further comprises a buffer memory (26) for registering the said parallel signals supplied from the said converting means (25).

## Patentansprüche

1. Verarbeitungsanordnung für PCM-Signale, die aus einem Fernsehformat-Signal decodiert werden und deren Fehler korrigiert werden, wobei das Fernsehformat-Signal eine Zeilenperiode hat, die einen Datenblock mit einer Vielzahl von Datenwörtern (Ln+21D, Rn+18D, Ln+1+15D, Rn+1+12D, Ln+2+9D, Rn+2+6D), mit einem Fehlerkorrekturprüfwort (Pn+3D, Qn) und mit einem Fehlerdetektorprüfwort (CRC) derart verschachtelt aufweist, daß aufeinanderfolgende Wörter in dem PCM-Signal in verschiedenen Blöcken des Fernsehformat-Signals auftreten,

mit einer Einrichtung (24) zum Demodulieren des betreffenden Datenblocks aus einem ihr eingangsseitig zugeführten Fernsehformat-Signal,

mit einer Einrichtung (25) zum Umsetzen des betreffenden Datenblocks in Parallelsignale, die kennzeichnend sind für einzelne Datenwörter, für das Fehlerkorrekturprüfwort bzw. für das Fehlerdetektorprüfwort.

mit einer Einrichtung (27) zum Entschachteln der betreffenden Parallelsignale mit Ausnahme des Fehlerdetektorprüfwortes,

mit einer Einrichtung (30) für die Ausgabe der Paralleldatenwörter,

mit einer Einrichtung (28) zum Korrigieren von Fehlern in den betreffenden Datenwörtern,

mit einer Einrichtung (31) für die Erzeugung eines Syndromwortes durch Kombinieren der entschachtelten Parallelwörter und Abgabe des betreffenden Syndromwortes an die Fehlerkorrektureinrichtung, derart, daß eine Fehlerkorrektur durch Kombinieren des betreffenden Syndromwortes mit den einzelnen Fehlern in den Datenwörtern durchgeführt wird,

mit einer Einrichtung (32) für die Ermittlung eines Blockfehlers in dem genannten Datenblock durch Überprüfen der parallel umgesetzten Datenwörter und des Fehlerkorrekturprüfwortes mit dem Fehlerdetektorprüfwort,

mit einer Einrichtung (40) für eine Verzögerung von Fehlerzeigern (Ep), die von der Blockfehler-Detektoreinrichtung abgegeben werden, derart, daß eine Vielzahl von unterschiedlich verzögerten Fehlerzeigern (EpLn, EpRn, EpLn+1, EpRn+1, EpRn+1, EpLn+2, EpRn+2, EpPn, EpQn) abgegeben wird, die hinsichtlich ihrer Verzögerungsbeträge den betreffenden entschachtelten Datenwörtern und dem Fehlerkorrekturprüfwort entsprechen,

mit einer Einrichtung (33) zur Ermittlung eines Fehlerzeigermusters aus einzelnen der entschachtelten Datenwörter und dem Fehlerkorrekturprüfwort unter Heranziehung der genannten Fehlerzeiger, die von der Fehlerzeiger-Verzögerungseinrichtung abgegeben werden,

und mit einer Einrichtung (34) für die Steuerung des Fehlerkorrekturbetriebs der genannten Fehlerkorrektureinrichtung durch Heranziehen der von der Fehlerzeigermuster-Detektoreinrichtung abgegebenen Ausgangssignale, dadurch gekennzeichnet, daß die Fehlerzeiger-Verzögerungseinrichtung ein Schieberegister (41 oder 42) umfaßt, welches eine Vielzahl von den genannten Verzögerungsbeträgen entsprechenden Ausgängen aufweist.

2. Verarbeitungsanordnung für PCM-Signale nach Anspruch 1, dadurch gekennzeichnet, daß die Fehlerzeiger-Verzögerungseinrichtung ein Serien-Schieberegister (41) umfaßt.

3. Verarbeitungsanordnung für PCM-Signale nach Anspruch 1, dadurch gekennzeichnet, daß die Fehlerzeiger-Verzögerungseinrichtung ein Parallel-Schieberegister (42) umfaßt.

4. Verarbeitungsanordnung für PCM-Signale nach einem der Ansprüche 1 bis 3, dadurch gekennzeichnet, daß ferner eine Einrichtung (29, 35) vorgesehen ist, welche Fehler der genannten entsschachtelten Datenwörter kompensiert, wozu ihre vorhergehenden Ausgangssignale herangezogen werden, die um einen Block verzögert rückgekoppelt sind, und daß die den Fehlerkorrekturbetrieb steuernde Einrichtung (34) so geschaltet ist, daß sie die genannte Fehlerkompensationseinrichtung steuert.

5. Verarbeitungsanordnung für PCM-Signale nach einem der vorhergehenden Ansprüche, dadurch gekennzeichnet, daß sie ferner einen Pufferspeicher (26) umfaßt, der die von der genannten Umsetzeinrichtung (25) abgegebenen Parallelsignale registriert.

**Revendications**

1. Un dispositif de traitement de signaux MIC servant à décoder des signaux MIC et à corriger leurs erreurs, en partant d'un signal de format télé dont la période horizontale comprend un bloc de données comprenant plusieurs mots de données (Ln+21D, Rn+18D, Ln+1+15D, Rn+1+12D, Ln+2+9D, Rn+2+6D), un mot de contrôle de correction d'erreurs (Pn+3D, Qn), et un mot de contrôle de détection d'erreurs (CRC), imbriqués de sorte que des mots successifs du signal MIC se trouvent dans des blocs différents du signal de format télé, ce dispositif de traitement comprenant:

des moyens (24) de démodulation du bloc de données en partant d'un signal de format téle qui leur est amené;

des moyens (25) de conversion du bloc de données en signaux parallèles représentant respectivement des mots de données individuels, le mot de contrôle de correction d'erreurs et le mot de contrôle de détection d'erreurs;

des moyens (27) de désimbrication des signaux parallèles, excepté le mot de contrôle de détection d'erreurs;

des moyens (30) de sortie des mots de données parallèles;

des moyens (28) de correction d'erreurs de ces mots de données;

des moyens (31) servant à former un mot de syndrome en combinant les mots parallèles désimbriqués et à appliquer ce mot de syndrome aux moyens de correction d'erreurs de façon que la correction des erreurs s'effectue par combinaison du mot de syndrome avec les erreurs individuelles des mots;

des moyens (32) servant à détecter une erreur de bloc du bloc de données en contrôlant les mots de données convertis en parallèle et le mot de contrôle de correction d'erreurs avec le mot de contrôle de détection d'erreurs;

des moyens (40) servant à retarder des indicateurs d'erreurs (Ep) sortant des moyens de détection d'erreurs de bloc de manière à faire sortir plusieurs indicateurs d'erreur retardés différemment (EpLn, EpRn, EpLn+1, EpRn+1, EpLn+2, EpRn+2, EpPn, EpQn), les indicateurs d'erreurs respectifs correspondant, en ce qui concerne leurs grandeurs de retard, aux mots de données désimbriqués respectifs et au mot de contrôle de corrections d'erreurs;

des moyens (33) de détection de configuration d'indicateur d'erreurs de mots de données désimbriqués individuels et du mot de contrôle de correction d'erreurs, avec utilisation des indicateurs d'erreurs fournis par les moyens de retard d'indicateurs d'erreurs, et

des moyens (34) de commande de l'opération de correction d'erreurs des moyens de correction d'erreurs, avec utilisation de signaux de sortie fournis par les moyens de détection de configuration d'indicateur d'erreurs, caractérisé en ce que:

les moyens de retard d'indicateur d'erreurs comprennent un registre à décalage (41 ou 42) présentant plusieurs sorties correspondant respectivement aux grandeurs de retard.

2. Un dispositif de traitement de signaux MIC selon la revendication 1, caractérisé en ce que lesdits moyens de retard d'indicateur d'erreurs comprennent un registre à décalage du type en série (41).

3. Un dispositif de traitement de signaux MIC selon la revendication 1, caractérise en ce que lesdits moyens de retard d'indicateur d'erreurs comprennent un registre à décalage du type en parallèle (42).

4. Un dispositif de traitement de signaux MIC selon l'une quelconque des revendications 1 à 3, caractérisé en ce qu'il comprend en outre des moyens (29, 35) servant à compenser des erreurs des mots de données désimbriqués en utilisant des signaux de sortie précédents, appliqués en réaction avec un retard d'un bloc, et que lesdits moyens de commande de l'opération de correction d'erreurs (34) sont reliés de manière à commander lesdits moyens de compensation d'erreurs.

5. Un dispositif de traitement de signaux MIC selon l'une quelconque des revendications précédentes, caractérisé en ce qu'il comprend en outre une mémoire tampon (26) servant à enregistrer lesdits signaux parallèles provenant desdits moyens de conversion (25).

# FIG. 1

CK

0.1V

HS

| | Ln | Rn-3D | Ln+1-6D | Rn+1-9D | Ln+2-12D | Rn+2-15D | Pn-18D | Qn-21D | CRC | |

14 bits

16 bits

W

HS

13 bits

13 bits

4 bits

128 bits

1 bit

4 bits

168 bits

# FIG. 2

CK

0.1V

HS

| | S | T | U | CT | CRC | |

14 bits

14 bits

W

HS

56 bits

28 bits

16 bits

13 bits

13 bits

4 bits

128 bits

1 bit

4 bits

168 bits

FIG. 3

CK

W

0.1V

| Ln | Rn-3D | Ln+1-6D | Rn+1-9D | Ln+2-12D | Rn+2-15D | Pn-18D | C R C |

HS

HS

13bits

13bits

4 bits

128bits

16bits

1 bit

4bits

168bits

FIG. 4A

EP

VS

CDB

DB

BL

3H | 3H | 3H | 1H | 245 H | 7.5H

262.5 H

FIG. 4B

EP

VS

CDB

DB

BL

3H | 3H | 35H | 1H | 245H | 7H

262.5H

0 048 151

FIG. 5

FIG. 6

0 048 151

FIG.7

FIG. 8